# EUROPEAN PATENT APPLICATION

(11) **EP 3 290 559 A1**
(43) Date of publication of application: **07.03.2018**
(21) Application number: 16785841.4
(22) Date of filing: 15.04.2016
(51) Int. Cl.: D06F 33/02, D06F 39/10, D06F 39/08, B01F 7/02, C02F 1/52, G01R 31/34

(54) **METHOD FOR JUDGING FAULT OF STIRRING MECHANISM IN FLOCCULATION PROCESS AND WASHING MACHINE**

(30) Priority: 28.04.2015 CN 201510205864
(71) Applicant: Qingdao Haier Washing Machine Co., Ltd., Shandong 266101 (CN)
(72) Inventor: XU, Sheng, Qingdao Shandong 266101 (CN); DENG, Jinzhu, Qingdao Shandong 266101 (CN); LI, Dong, Qingdao Shandong 266101 (CN)
(74) Representative: Ziebig, Marlene
(86) International application number: PCT/CN2016/079404
(87) International publication number: WO 2016/173410

(57) **Abstract**

The present disclosure discloses a washing machine and a method for fault determination for a stirring mechanism in a flocculation treatment process. The washing machine comprises a flocculation container (1) for flocculation treatment on washing water; the stirring mechanism driven by a motor (6) to rotate is arranged in the flocculation container (1); the motor (6) is provided with a current meter for detecting working current of the motor (6); and the stirring mechanism is provided with a rotating speed sensor for detecting the rotating speed of the stirring mechanism. The method comprises the following steps that when the washing machine executes a flocculation program, the stirring mechanism is driven by the motor (6) to work, working current I and/or power P of the motor (6) are detected, and rotating speed V of the stirring mechanism is detected; and when any one of detection values is beyond a corresponding setting range, a fault alarm signal of the stirring mechanism is given out. Through the adoption of the device and the method, a fault of the stirring mechanism can be accurately determined in time, so that the condition that water which does not complete the flocculation reaction returns to the washing barrel and pollutes clothes can be prevented. Besides, the washing machine disclosed by the present disclosure is simple in structure, the method is concise, the effect is significant, and the washing machine and the method are suitable for being popularized and applied.

## Description

### TECHNICAL FIELD

The present disclosure relates to a washing machine performing self-cleaning treatment on water in a flocculation manner, belonging to the field of washing machines, particularly to a method for fault determination for a stirring mechanism in a flocculation treatment process. And further relates to a washing machine equipped with the stirring mechanism and performing fault determination for the stirring mechanism by the aforementioned method.

### BACKGROUND

With the improvement of people's living standards, washing machines have become one of major household appliances in people's daily life. The washing processes of a washing machine mainly comprise several stages of washing, rinsing and dewatering. In the washing stage, water and detergent are fed into the washing machine, and clothes are washed. And after the rinsing stage begins, in order to rinse out dirt and the residual detergent, much water is needed or more times of rinsing needs to be performed to rinse the clothes, so that a large amount of water is consumed. Even if a water-saving drum washing machine is used, the clothes also need to be rinsed at least twice to get cleaned, and at least 30L or more running water needs to be consumed in the process. Sometimes, less dirt is on the clothes or less amount of the detergent is used, the clothes can be cleaned after being rinsed two times. But because a user selects three times of rinsing, waste of water can be caused. For example, a 6Kg full-automatic washing machine generally consumes about 100 litres of water for rinsing two times. How to thoroughly wash clothes and save water and electricity at the same time is one of the focuses of consumers.

In view of this, the applicant has filed a Chinese patent application with the application number of 201310356428.5, which relates to a washing machine with a circulating water treatment function and a control method. The washing machine comprises a water containing barrel, a clothes washing structure arranged in the water containing barrel and a circulating water treatment device arranged under the water containing barrel, wherein the circulating water treatment device comprises a flocculation treatment unit and a filtering unit. The flocculation treatment unit comprises a flocculation container communicating with the water containing barrel, and a flocculant deliverer for delivering a flocculant into the flocculation container, and water is discharged from the water containing barrel to the flocculation container for flocculation treatment. The filtering unit comprises a filtering container and a filtering screen arranged in the filtering container, the filtering container communicates with the flocculation container and the water containing barrel, and water after flocculation treatment in the flocculation container is filtered and re-discharged into the water containing barrel for reuse. In this patent application, the flocculation filtration-treated water is circulated until washing is finished, and the water is discharged into the circulating water treatment device for cleaning of the flocculation treatment unit and the filtering unit, and then is drained. The flocculation washing machine provided by this patent application has the characteristics that water is saved, water pollution is reduced, and the environment is protected.

When flocculation treatment is performed on the washing water or rinsing water by a conventional flocculation container, dirt in the water will react with the flocculant, and flocculates are generated. The generated flocculates precipitate or float, so that water and dirt are separated, and the purpose of purifying the washing water and/or the rinsing water is achieved. In the process of the reaction, in order to improve the reaction rate and efficiency to achieve an expected purpose, generally, a stirring mechanism for stirring water flows needs to be added in the flocculation container, so that the flocculant can be rapidly dissolved and uniformly mixed, and a desired separation effect is achieved.

However, when abnormality of the stirring mechanism and a motor driving the stirring mechanism to rotate occurs and is not found in time, water that has not been treated successfully is prone to return to the washing barrel, so that clothes in the washing barrel are polluted.

In view of this, the present disclosure is proposed.

### SUMMARY

The technical problem to be solved in the present disclosure is to overcome defects in the prior art, and the present disclosure provides a method for fault determination for a stirring mechanism in a flocculation water treatment process to achieve the purpose of timely detection and accurate determination of a fault of the stirring mechanism.

In order to achieve the purpose, the present disclosure adopts the technical scheme with the following basic conception:
a method for fault determination for a stirring mechanism in a flocculation treatment process, comprises the steps that when a washing machine executes a flocculation program, the stirring mechanism is driven by a motor to work, working current I and/or power P of the motor are detected, and rotating speed V of the stirring mechanism is detected; and when any one of detection values is beyond a corresponding setting range, a fault alarm signal of the stirring mechanism is given out.

Further, when the washing machine executes the flocculation program, a fault determination process of the stirring mechanism comprises the following steps that
step S101, the washing machine executing the flocculation program, and the stirring mechanism in a flocculation container being driven by the motor to start rotating;
step S102, detecting the working current of the motor in real time to obtain a detection value I of the working current; and when the detection value I is within a setting range of Iₘᵢₙ to Iₘₐₓ, the stirring mechanism works normally; and
step S103, detecting the rotating speed of the stirring mechanism in real time to obtain a detection value V of the rotating speed; and when the detection value V is within a setting range of Vₘᵢₙ to Vₘₐₓ, the stirring mechanism works normally, and the washing machine continuing executing the flocculation program.

Further, when the detection value I of the working current of the motor is greater than the setting value Iₘₐₓ, the washing machine gives out an alarm signal indicating hindered rotation of a motor shaft and/or the stirring mechanism. And when the detection value I of the working current of the motor is less than the setting value Iₘᵢₙ, the washing machine gives out an alarm signal indicating disengagement of the motor shaft from the stirring mechanism as well as idling of the motor shaft.

Further, when the detection value I of the working current of the motor is not within the setting range of Imin to Imax, the flocculation program executed by the washing machine is suspended, and a corresponding alarm signal is given out.

Further, when the washing machine executes the flocculation program, a fault determination process of the stirring mechanism comprises the following steps that
step S201, the washing machine executing the flocculation program, and the stirring mechanism in a flocculation container being driven by the motor to start rotating;
step S202, detecting the working power of the motor in real time to obtain a detection value P of the working power; and when the detection value P is within a setting range of Pₘᵢₙ to Pₘₐₓ, the stirring mechanism works normally; and
step S203, detecting the rotating speed of the stirring mechanism in real time to obtain a detection value V of the rotating speed; and when the detection value V is within a setting range of Vₘᵢₙ to Vₘₐₓ, the stirring mechanism works normally, and the washing machine continuing executing the flocculation program.

Further, when the detection value V of the rotating speed of the stirring mechanism is less than the setting value Vₘᵢₙ, it is determined that the motor is disengaged from the stirring mechanism.

Further, the stirring mechanism is in transmission connection with the motor shaft through a belt, and the stirring mechanism is driven by the motor through the belt to rotate around a corresponding shaft so as to stir water in the flocculation container. When the detection value V of the rotating speed of the stirring mechanism is less than the setting value Vₘᵢₙ, and is greater than the setting value V₁, it is determined that belt slippage occurs. When the detection value V of the rotating speed is less than the setting value V₁, it is determined that the belt is disengaged from the motor and/or the stirring mechanism. The setting value V₁ is less than Vₘᵢₙ.

Further, when the detection value V of the rotating speed of the stirring mechanism is within a setting range of 70-80 rpm, the stirring mechanism works normally, and the washing machine continues executing the flocculation program. When the detection value V of the rotating speed of the stirring mechanism is within a setting range of 60-70 rpm, the washing machine gives out a prompt signal indicating belt slippage; and when the detection value V of the rotating speed of the stirring mechanism is below 60 rpm, the washing machine gives out an alarm signal indicating disengagement of the belt from the motor shaft and/or the stirring mechanism, and the flocculation program of the washing machine is suspended.

Further, the stirring mechanism rotates around a rotating shaft which is in transmission connection with an output shaft of the motor through a belt, and the stirring mechanism is driven by the motor through the belt to rotate around the shaft; or
the stirring mechanism rotates around the rotating shaft which penetrates through the flocculation container, and the penetrating-out end is in meshed connection with the motor so as to enable the motor to directly drive the stirring mechanism to rotate around the shaft.

Further, the washing machine is provided with a display panel for displaying and feeding back corresponding fault information of the stirring mechanism to a user; and the washing machine is provided with an alarm light and/or an alarm horn for giving out a prompt signal when the stirring mechanism has a fault and stops in the flocculation process.

Further, the washing machine is in remote connection with a maintenance platform to upload fault information of the stirring mechanism to an after-sale system so as to facilitate maintenance by staff.

Another object of the present disclosure further is to provide a washing machine, the washing machine comprises a flocculation container for flocculation treatment on washing water; a stirring mechanism is arranged in the flocculation container and is driven by a motor to rotate so as to stir water in the flocculation container. The motor is provided with a current meter for detecting working current of the motor; and the stirring mechanism is provided with a rotating speed sensor for detecting the rotating speed of the stirring mechanism; and the washing machine performs fault determination on the stirring mechanism by the method according to any one of above methods.

Further, the stirring mechanism comprises a stirrer which is driven by a drive motor to rotate; the stirrer comprises a rotating shaft, and a plurality of stirring blades rotating around the rotating shaft are connected to the rotating shaft; and a belt pulley is arranged on the rotating shaft, and the belt pulley is in transmission connection with an output end of the drive motor through a belt so as to enable the drive motor to drive the stirring blades to rotate around the rotating shaft.

Further, the stirring mechanism comprises a stirrer which is driven by a drive motor; the stirrer comprises a rotating shaft, and a plurality of stirring blades rotating around the rotating shaft are connected to the rotating shaft. And one end of the rotating shaft penetrates through the side wall of the flocculation container, and a penetrating-out end is directly in meshed connection with the drive motor which is arranged at a corresponding position on the outer wall of the flocculation container so as to enable the drive motor to directly drive the stirring blades to rotate around the rotating shaft.

Further, the rotating speed sensor consists of a Hall sensor, and the specific structure of the rotating speed sensor is as follows: one or more pieces of magnetic steel are fixed in the same circumference of the belt pulley, a Hall element is fixed to a corresponding circumference on the outer side of the wall of the flocculation container for receiving signals, and the signals are transmitted to a control panel of the washing machine through a signal line. The control panel calculates the rotating speed of the stirring mechanism by converting the number of signals received per unit time, and the setting ranges of Vₘᵢₙ to Vₘₐₓ and Iₘᵢₙ to Iₘₐₓ are preset in the control panel.

Further, in order to improve the flocculation efficiency and to clean the flocculation container, one or more cleaning granules are arranged in the flocculation container, so that the cleaning granules move along with water flows in the flocculation container to rub and clean the wall of the flocculated container, and the purpose of thoroughly cleaning flocculates adhered to the inner wall of the flocculation container is achieved.

Compared with the prior art, the method and the washing machine disclosed by the present disclosure has the following beneficial effects:
1. The working current and power of the motor as well as the rotating speed of the stirring mechanism are detected in real time, and when the working current or power or the rotating speed is beyond the setting ranges, a fault of the stirring mechanism can be detected in time and can be classified and determined accurately, so that the condition that water which does not complete the flocculation reaction returns to the washing container and pollutes clothes can be prevented.
2. Through adoption of the above method and device, the washing machine can perform accurate judgement on the working current and power as well as the rotating speed with the corresponding preset ranges, so that the purpose of timely and accurate determination on the fault of the stirring mechanism can be achieved.
3. The stirring mechanism is connected with the motor at the upper part of the flocculation container through the belt, and through comparison judgement between the working current and power as well as the rotating speed with the corresponding preset ranges, the washing machine can automatically and accurately determines that the fault of the stirring mechanism is which of slippage or disengagement of the belt or hindered rotation of the stirring mechanism, and corresponding prompt information is given out in time as well as the flocculation program of the washing machine is suspended, so that the purposes of accurately determining a fault of the stirring mechanism and giving an alarm are achieved.
4. A stirring mechanism connected with the motor through any conventional transmission structure is applicable to the fault determination method disclosed by the present disclosure, so that the fault determination method disclosed by the present disclosure is wide in application scope and is suitable for standardization promotion.

Besides, the method disclosed by the present disclosure is concise and significant in effect, and is suitable for being popularized and applied.

Embodiments of the present disclosure are described in details below with reference to the accompanying drawings.

### BRIEF DESCRIPTION OF DRAWINGS

Fig. 1 is a schematic diagram of an embodiment of the present disclosure;
Fig. 2 and Fig. 3 are schematic diagrams of a circulating water treatment device of the embodiment of the present disclosure;
Fig. 4 and Fig. 5 are flow charts of a method for fault determination for a stirring mechanism of the embodiment of the present disclosure;
Fig. 6 is a schematic diagram of a circulating water treatment device of another embodiment of the present disclosure; and
Fig. 7 is a flow chart of a method for fault determination for a stirring mechanism of another embodiment of the present disclosure.

Description of main elements: 1-flocculation container; 2-first water pump; 3-second water pump; 4-drain valve; 5-stirring blade; 6-drive motor; 7-belt; 8-belt pulley; 9-cleaning granule; 10-rotating shaft; 11-motor shaft; 12-driving wheel.

### DETAILED DESCRIPTION

The present disclosure is described in further detail below in conjunction with the embodiments.

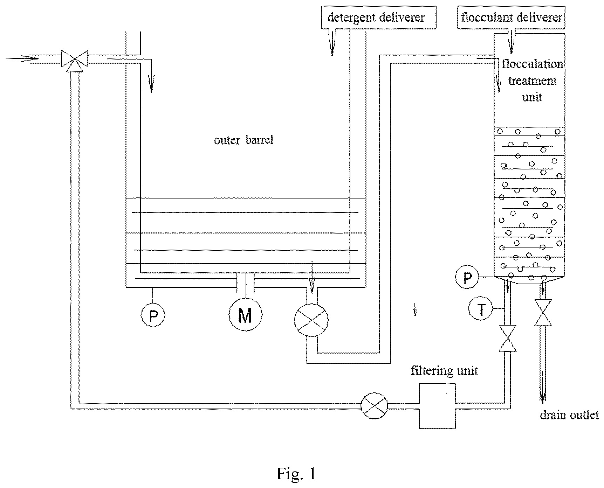

As shown in Fig. 1, a washing machine of the embodiment of the present disclosure is internally provided with a conventional washing machine structure and is provided with a circulating water treatment device. The washing machine structure comprises an outer barrel, an inner barrel arranged in the outer barrel, a door body, a control panel, a water inlet system and a washing motor, the bottom and the upper part of the outer barrel are connected with a casing framework through a damper and a suspension spring, respectively. And the water inlet system comprises a water inlet structure and an automatic detergent delivery device. The outer barrel is in a containing structure for containing washing water, and the inner barrel arranged in the outer barrel is clothes washing structure. The outer barrel communicates with the water inlet structure.

The circulating water treatment device in the embodiment of the present disclosure at least comprises a flocculation treatment unit; the flocculation treatment unit comprises a flocculation container communicating with the outer barrel and a flocculant deliverer for delivering a flocculant into the flocculation container, and water is discharged from the outer barrel to the flocculation container for flocculation treatment.

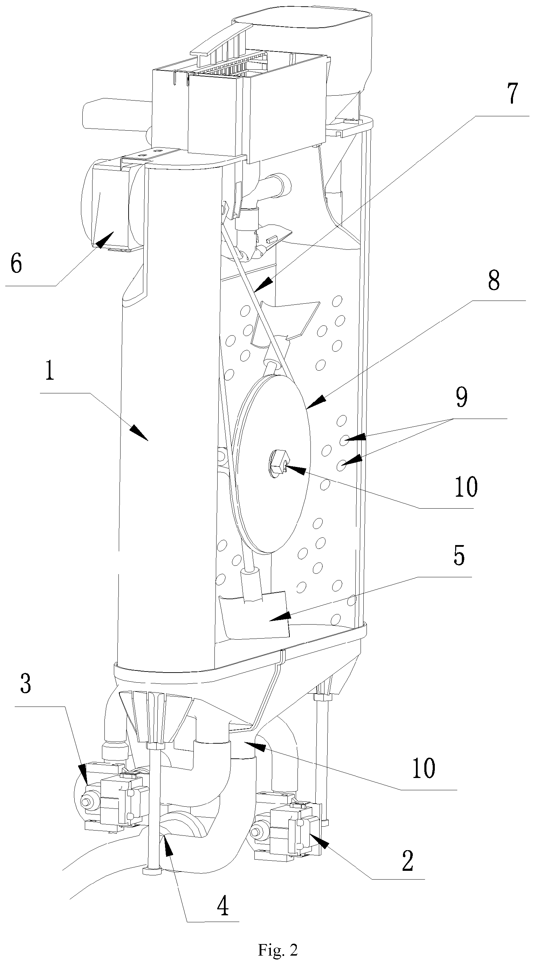

As shown in Fig. 2, Fig. 3 and Fig. 6, the flocculation container 1 is provided with a water inlet, a water return opening and a drain outlet; a water outlet of the outer barrel communicates with the water inlet of the flocculation container 1 through a conduit provided with a first water pump 2, and the water return opening of the flocculation container 1 communicates with a water inlet of the outer barrel through a conduit provided with a second water pump 3, so that a controllable circulation loop of washing water between the outer barrel and the flocculation container 1 is formed. A drain outlet of the flocculation container 1 communicates with the outside of the washing machine through a conduit provided with a drain valve 4, so that sewage and flocculates after washing are drained.

Preferably, the circulating water treatment device further comprises a filtering unit which performs filtration treatment on flocculation treatment water after treatment of the flocculation treatment unit to separate flocculates and clean water. However, flocculates can also be separated from clean water without using a filtering device. For example, a water level sensor is arranged in the flocculation container to enable the water level in the flocculation container to always maintain at a certain height, so that flocculates floating at the water surface of the flocculation container always stay in the flocculation container, and the purpose of removing the flocculates in the flocculation water is also achieved.

As shown in Fig. 2, Fig. 3 and Fig. 6, in the embodiment of the present disclosure, a stirring mechanism is arranged in the flocculation container, and the stirring mechanism can be a device of any structure in the prior art and is capable of stirring water in the flocculation container. The stirring mechanism is driven by a motor to rotate to stir water in the flocculation container. However, when the stirring mechanism has a fault, water that does not complete flocculation treatment in the flocculation container is prone to return to the outer barrel, and clothes are polluted.

Therefore, in the embodiment of the present disclosure, the motor is provided with a current meter for detecting working current of the motor and/or a detection device for detecting working power of the motor, and the stirring mechanism is provided with a rotating speed sensor for detecting rotating speed of the stirring mechanism. The working current and power of the motor as well as the rotating speed of the stirring mechanism are detected in real time, and when the working current or power or the rotating speed is beyond setting ranges, a fault of the stirring mechanism can be detected in time and can be classified and determined accurately, so that the condition that water which does not complete the flocculation reaction returns to the washing barrel and pollutes clothes can be prevented.

### Embodiment 1

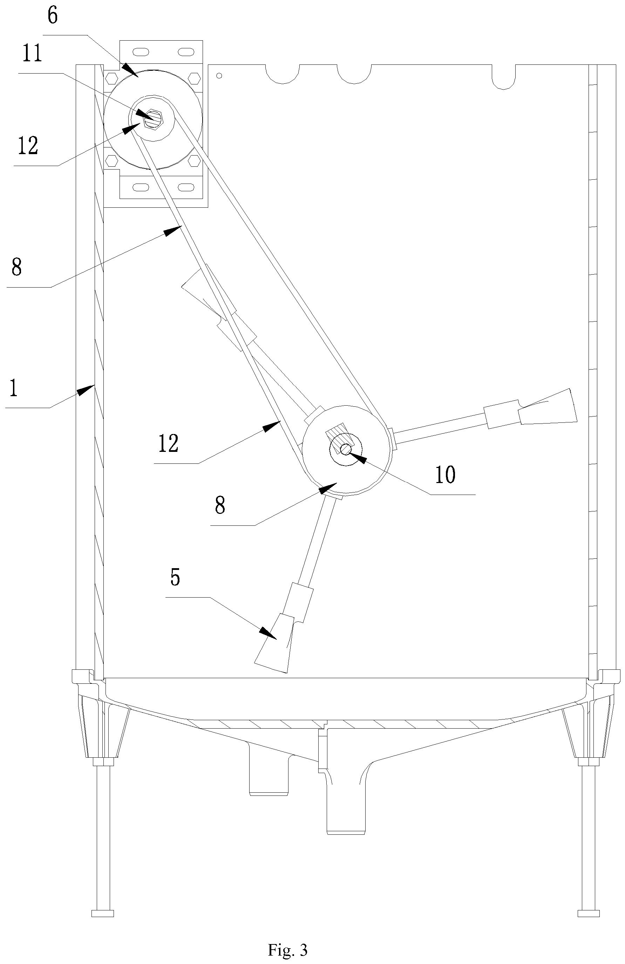

As shown in Fig. 2 and Fig. 3, in this embodiment, a stirring mechanism in a flocculation container 1 comprises a stirrer which is driven by a drive motor 6 to rotate; the stirrer comprises a rotating shaft 10, and a plurality of stirring blades 5 rotating around the rotating shaft 10 are connected to the rotating shaft 10. And a belt pulley 8 is arranged on the rotating shaft 10, and the belt pulley 8 is in transmission connection with an output end of the drive motor 6 through a belt 7 so as to enable the drive motor 6 to drive the stirring blades 5 to rotate around the rotating shaft 10 through the transmission of the belt.

In this embodiment, the drive motor 6 is fixedly mounted on the outer side of the side wall of the flocculation container 1 and is arranged in a position beyond the water level of the flocculation container 1, a motor shaft 11 penetrates through the side wall of the flocculation container 1, and a penetrating-in end of the motor shaft 11 is in contact transmission with the belt 7 through a driving wheel 12 or directly. Because the drive motor is arranged in the position above the water level of the flocculation container, water in the flocculation container is not in contact with the drive motor, and a step of water seal treatment on the part, penetrating through the side wall position of the flocculation container, of the motor shaft, is omitted.

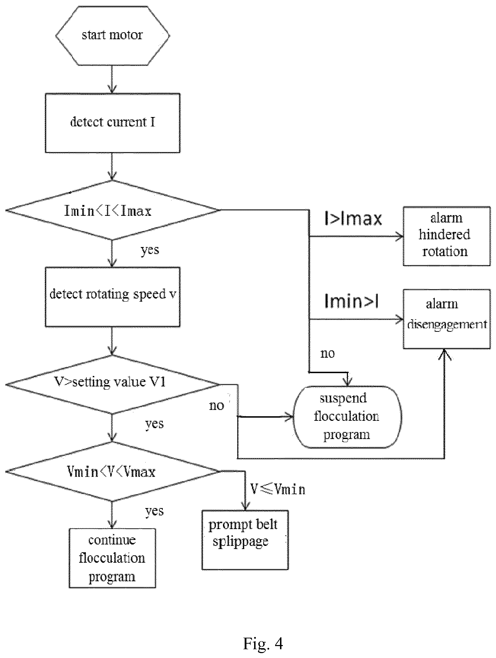

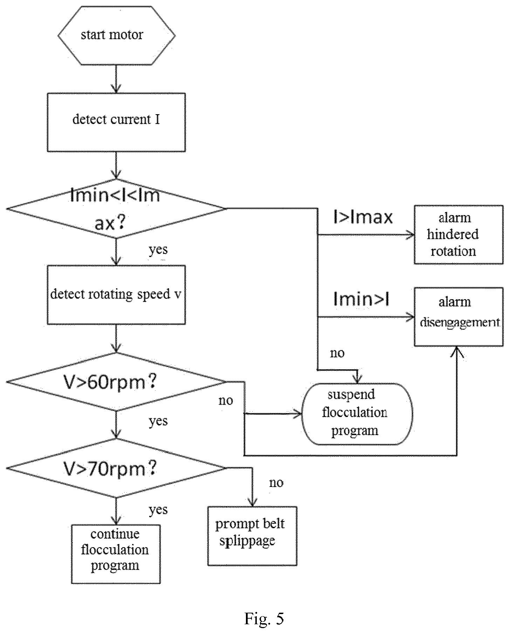

As shown in Fig. 4 and Fig. 5, in this embodiment, a method for fault determination for the stirring mechanism in a flocculation reaction process of the washing machine specially comprises the following steps that:
11) the washing machine executing a flocculation program, and the stirring mechanism in the flocculation container being driven by the drive motor to start rotating;
12) detecting working current of the drive motor in real time to obtain a detection value I of the working current;
13) comparing the detection value I with preset values Iₘₐₓ and Iₘᵢₙ:
   when I is greater than Iₘᵢₙ and less than Iₘₐₓ, step 14) is executed;
   when I is greater than Iₘₐₓ, step 15) is executed; and
   when I is less than Iₘᵢₙ, step 16) is executed;
14) detecting rotating speed of the stirring blades in real time to obtain a detection value V of the rotating speed;
15) comparing the detection value V with preset values Vₘᵢₙ and Vₘₐₓ:
   when V is greater than Vₘᵢₙ and less than Vₘₐₓ, step 19) is executed;
   when V is greater than V₁ and less than Vₘᵢₙ, step 18) is executed, wherein V₁ is a preset value less than Vₘᵢₙ; and
   when V is less than V₁, step 17) is executed;
16) the washing machine giving out a prompt signal indicating hindered rotation of the motor shaft and/or the stirring blades, and the flocculation program being suspended;
17) the washing machine giving out a prompt signal indicating disengagement of the belt from the motor shaft and/or the driving wheel and/or the belt pulley as well as idling of the motor shaft, and the flocculation program is suspended;
18) the washing machine giving out a prompt signal indicating belt slippage; and
19) the stirring program works normally, and the flocculation program continuing executing.

Through the adoption of the method and device, the washing machine performs comparison judgement of the working current of the drive motor and the rotating speed of the stirring mechanism with the corresponding preset ranges, so that whether a fault of the stirring mechanism occurs can be determined in time; besides, it can be accurately determined that the fault of the stirring mechanism is which of slippage or disengagement of the belt or hindered rotation of the stirring mechanism according to the comparison result, and corresponding prompt information can be given by the washing machine automatically and accurately, so that the purpose of accurate determination on the fault of the stirring mechanism can be achieved; and when the stirring mechanism has a fault, the washing machine automatically stops the flocculation reaction, so that pollution to clothes is prevented.

In this embodiment, after the step 18) is executed by the washing machine, cleanliness detection needs to be performed in advance on recirculation water after flocculation is completed, and the flocculation water can be returned if the cleanliness meets the washing requirements, so that the condition that water which does not complete the flocculation reaction because of belt slippage returns to the washing barrel and pollutes clothes can be prevented.

Preferably, as shown in Fig. 5, in this embodiment, many times of tests show that the maximum rotating speed Vₘₐₓ of the stirring device is 80 rpm, the minimum rotating speed Vₘᵢₙ of the stirring device during normal rotation of the stirring device is 70 rpm, the maximum rotating speed V₁ of the stirring device after belt disengagement is 60 rpm, and these values are preset in the program of the washing machine, so that Vₘₐₓ, Vₘᵢₙ and V₁ in the steps from 11) to 19) are correspondingly set to be 80, 70 and 60 rpm in sequence. At the same time, the corresponding Iₘᵢₙ and Iₘₐₓ are set according to the size of the stirring blades and the model of the drive motor; and it should be guaranteed that Iₘₐₓ is less than or equal to the locked-rotor current of the motor, and Iₘᵢₙ is greater than or equal to the idling current of the motor.

In this embodiment, when the washing machine executes the steps 16) and 17), the washing machine stops working, and displays corresponding fault prompt information in a control display of the washing machine. Preferably, the washing machine is provided with an alarm light and/or an alarm horn to give out a corresponding alarm signal to a user when the stirring mechanism has a fault.

In this embodiment, the washing machine can also be provided with a wireless signal transmission interface connected with the Internet, so that the washing machine can be in remote connection with a maintenance platform to upload the fault information of the stirring mechanism to an after-sales system to facilitate maintenance by staff.

In this embodiment, based on a formula P=UI, the working current I of the drive motor can be replaced with working power P of the drive motor, so that the power P of the drive motor can be detected, and the purpose of fault determination for the stirring mechanism can also be achieved by using the above-mentioned steps in this embodiment of the present disclosure.

### Embodiment 2

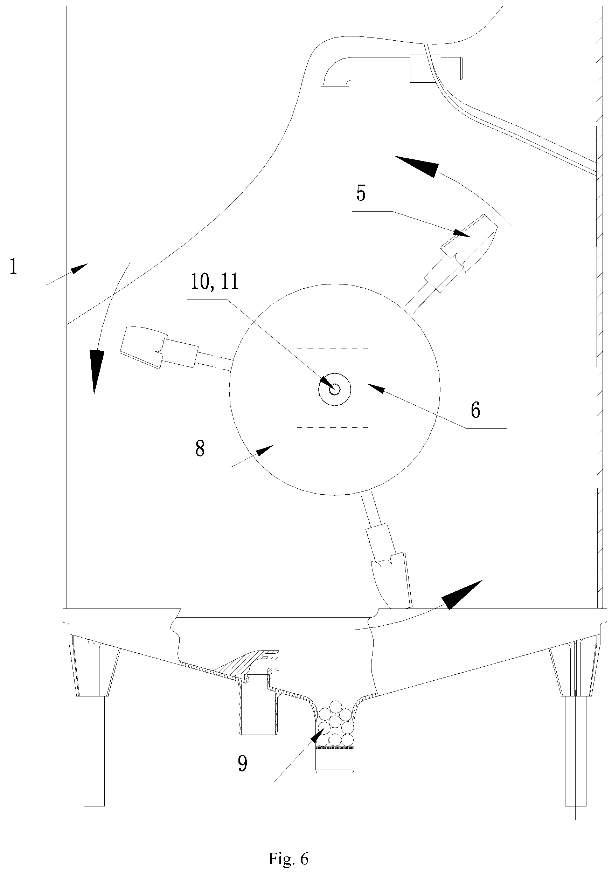

As shown in Fig. 6, in this embodiment, a stirring mechanism comprises a stirrer which is driven by a drive motor 6 to rotate; the stirrer comprises a rotating shaft 10, and a plurality of stirring blades 5 rotating around the rotating shaft 10 are connected to the rotating shaft 10. One end of the rotating shaft 10 penetrates through the side wall of the flocculation container 1, and a penetrating-out end is in meshed connection with a motor shaft 11 of the drive motor 6 arranged at a corresponding position of the outer wall of the flocculation container 1 so as to enable drive motor to directly drive the stirring blades to rotate around the rotating shaft. Preferably, the motor shaft 11 and the rotating shaft 10 are designed as one piece. The motor is directly in meshed transmission connection with the rotating shaft, so that the transmission connection between the motor and the stirring mechanism is firmer.

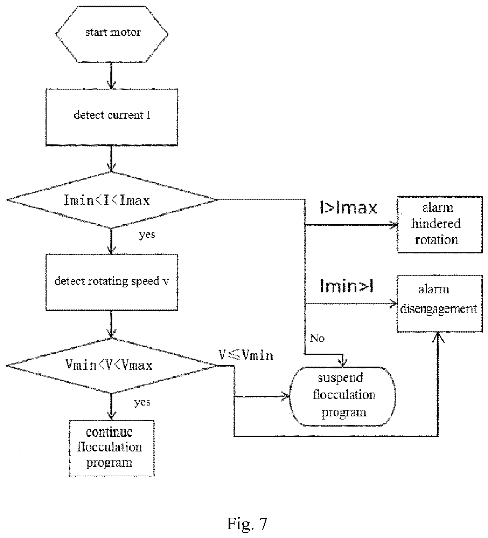

As shown in Fig. 7, in this embodiment, a method for fault determination for the stirring mechanism in a flocculation reaction process of the washing machine specially comprises the following steps that:
21) the washing machine executing a flocculation program, and the stirring mechanism in the flocculation container being driven by the drive motor to start rotating;
22) detecting working current of the drive motor in real time to obtain a detection value I of the working current;
23) comparing the detection value I with preset values Iₘₐₓ and Iₘᵢₙ:
   when I is greater than Iₘᵢₙ and less than Iₘₐₓ, step 24) is executed;
   when I is greater than Iₘₐₓ, step 25) is executed; and
   when I is less than Iₘᵢₙ, step 26) is executed;
24) detecting rotating speed of the stirring blades in real time to obtain a detection value V of the rotating speed;
25) comparing the detection value V with preset values Vₘᵢₙ and Vₘₐₓ:
   when V is greater than Vₘᵢₙ and less than Vₘₐₓ, step 28) is executed; and
   when V is less than Vₘᵢₙ, step 27) is executed;
26) the washing machine giving out a prompt signal indicating hindered rotation of the motor shaft and/or the stirring blades, and the flocculation program being suspended;
27) the washing machine giving out a prompt signal indicating disengagement of the motor shaft from the stirring device as well as idling of the motor shaft, and the flocculation reaction being suspended; and
28) the stirring program to work normally, and the flocculation program continuing executing.

In this embodiment, Vₘᵢₙ and Vₘₐₓ in the steps from 21) to 28) are correspondingly set to be 60 rpm and 80 rpm in sequence.

Through the adoption of the method and the device, relations between the working current and the rotating speed and the corresponding preset ranges are determined, and when hindered rotation of the stirring mechanism without adopting belt pulley transmission or disengagement of the stirring mechanism from the motor occurs, the washing machine automatically and accurately gives out corresponding prompt information and stops the flocculation reaction, so that the purpose of accurate determination on the fault of the stirring mechanism is achieved. Therefore, the fault determination method for the stirring mechanism disclosed by the present disclosure is applicable to a stirring mechanism without adopting belt pulley transmission, so that the scope of application of the control method disclosed by the present disclosure is wide.

### Embodiment 3

As shown in Fig. 2 and Fig. 3, in this embodiment, a plurality of cleaning granules 9 are arranged in the flocculation container 1, so that the flocculates attached to the flocculation container 1 can be removed, and the efficiency of flocculation reaction is improved.

In this embodiment, the cleaning granules 9 are spherical, square, elliptical, cylindrical, tetrahedral or other irregular bulk granular matters. Preferably, the cleaning granules are set to be spherical or elliptical, so that edges and corners are reduced, and the purpose of enlarging friction areas is achieved; besides, the probability that the cleaning granules are clamped by other structures in the flocculation container is reduced.

In this embodiment, the density of the cleaning granules 9 is slightly less than that of water; and preferably, the density of the cleaning granules 9 is 0.8 to 0.9999 times of that of the water. Therefore, the cleaning granules can move to any positions in the flocculation container along with the water flows, and the effect of cleaning all parts of the flocculation container is realized. Besides, conditions that the cleaning granules are too light and always stay in the water surface of the flocculation container, or the cleaning granules are too heavy and always stay at the bottom of the flocculation container, can be prevented.

### Embodiment 4

In this embodiment, a rotating speed sensor of the stirring mechanism consists of a Hall sensor, and the specific structure of the rotating speed sensor is as follows: one or more pieces of magnetic steel are fixed in the same circumference of the belt pulley 8, a Hall element for receiving signals is arranged on the side wall of the flocculation container 1, and the Hall element is fixed in a circumference corresponding to the belt pulley 8 (Not shown in the drawing).

In the rotation process of the belt pulley, when the magnetic steel rotates and passes by the Hall element, the Hall element can generate signals, and the signals are transmitted to the control panel of the washing machine through a signal line; and the control panel calculates the detection value V of the rotating speed of the stirring mechanism by converting the number of signals received per unit time.

Through the adoption of the arrangement, the rotating speed of the stirring mechanism can be detected accurately, so that the accuracy of the fault determination method disclosed by the present disclosure is improved.

What described above are only preferred embodiments of the present disclosure, but are not intended to limiting the conception and scope of the present disclosure in any forms. However, without departing from the design idea of the technical solution of the present disclosure, various changes and modifications made by those skilled in the art according to the technical essence of the present disclosure shall all be covered within the scope of the technical solution of the present disclosure.

## Claims

1. A method for fault determination for a stirring mechanism in a flocculation treatment process, comprising,
detecting a working current I and/or a power P of a motor which drives the stirring mechanism to work when a washing machine executes a flocculation program, and detecting a rotating speed V of the stirring mechanism;
and giving out a fault alarm signal of the stirring mechanism, when any one of detection values is beyond a corresponding setting range.

2. The method according to claim 1, **characterized in that** when the washing machine executes the flocculation program, the fault determination for the stirring mechanism comprises,
step S101, the washing machine executing the flocculation program, and the stirring mechanism in a flocculation container being driven by the motor to start rotating;
step S102, the working current of the motor being detected in real time to obtain a detection value I of the working current; and, the stirring mechanism working normally when the detection value I is within a setting range from Iₘᵢₙ to Iₘₐₓ; and
step S103, the rotating speed of the stirring mechanism being detected in real time to obtain a detection value V of the rotating speed; and the stirring mechanism working normally when the detection value V is within a setting range from Vₘᵢₙ to Vₘₐₓ, and the washing machine continuing executing the flocculation program.

3. The method according to claim 2, **characterized in that**:
when the detection value I of the working current of the motor is greater than the setting value Iₘₐₓ, the washing machine gives out an alarm signal indicating a hindered rotation of a motor shaft and/or the stirring mechanism; and
when the detection value I of the working current of the motor is less than the setting value Iₘᵢₙ, the washing machine gives out an alarm signal indicating a disengagement of the motor shaft from the stirring mechanism as well as an idling of the motor shaft.

4. The method according to claim 3, **characterized in that** when the detection value I of the working current of the motor is not within the setting range from Iₘᵢₙ to Iₘₐₓ, the flocculation program being executed by the washing machine is suspended, and a corresponding alarm signal is given out.

5. The method according to claim 1, **characterized in that** when the washing machine executes the flocculation program, the fault determination for the stirring mechanism comprises,
step S201, the washing machine executing the flocculation program, and the stirring mechanism in a flocculation container being driven by the motor to start rotating;
step S202, the working power of the motor being detected in real time to obtain a detection value P of the working power; and the stirring mechanism working normally when the detection value P is within a setting range from Pₘᵢₙ to Pₘₐₓ; and
step S203, the rotating speed of the stirring mechanism being detected in real time to obtain a detection value V of the rotating speed; and the stirring mechanism working normally when the detection value V is within a setting range from Vₘᵢₙ to Vₘₐₓ, and the washing machine continuing executing the flocculation program.

6. The method according to claim 2 or claim 5, **characterized in that** when the detection value V of the rotating speed of the stirring mechanism is less than the setting value Vₘᵢₙ, it is determined that the motor is disengaged from the stirring mechanism.

7. The method according to claim 2 or claim 5, **characterized in that** the stirring mechanism is in a transmission connection with the motor shaft through a belt, and the stirring mechanism is driven by the motor through the belt to rotate around a corresponding shaft so as to stir water in the flocculation container;
when the detection value V of the rotating speed of the stirring mechanism is less than the setting value Vₘᵢₙ, it is determined that a belt skids;
when the detection value V of rotating speed is less than a setting value V₁, it is determined that the belt is disengaged from the motor and/or the stirring mechanism; and the setting value V₁ is less than Vₘᵢₙ.

8. The method according to claim 7, **characterized in that** when the detection value V of the rotating speed of the stirring mechanism is within a setting range of 70-80rpm, the stirring mechanism works normally, and the washing machine continues executing the flocculation program;
when the detection value V of the rotating speed of the stirring mechanism is within a setting range of 60-70rpm, the washing machine gives out a prompt signal indicating the belt skids; and
when the detection value V of the rotating speed of the stirring mechanism is below 60rpm, the washing machine gives out an alarm signal indicating the disengagement of the belt from the motor shaft and/or the stirring mechanism, and the flocculation program of the washing machine is suspended.

9. A washing machine, comprising a flocculation container (1) for flocculation treatment on washing water, wherein,
a stirring mechanism is arranged in the flocculation container (1) and is driven by a motor to rotate so as to stir water in the flocculation container (1);
the motor is provided with a current meter for detecting working current of the motor, and the stirring mechanism is provided with a rotating speed sensor for detecting rotating speed of the stirring mechanism; and
the washing machine performs fault determination on the stirring mechanism by the method according to any one of claims from 1 to 8.

10. The washing machine according to claim 9, **characterized in that** the stirring mechanism comprises a stirrer which is driven by a drive motor (6) to rotate; the stirrer comprises a rotating shaft, and a plurality of stirring blades (5) rotating around the rotating shaft are connected to the rotating shaft; and a belt pulley is arranged on the rotating shaft, and the belt pulley is in a transmission connection with an output end of the drive motor (6) through a belt so as to enable the drive motor (6) to drive the stirring blades (5) to rotate around the rotating shaft.
